# EUROPÄISCHE PATENTSCHRIFT

(11) **EP 2 095 394 B1**
(45) Veröffentlichungstag und Bekanntmachung des Hinweises auf die Patenterteilung: **30.03.2016**
(21) Anmeldenummer: 07856234.5
(22) Anmeldetag: 23.11.2007
(51) Int. Cl.: H01J 37/32

(54) **DEZENTRALE PLASMA-ARCSTEUERUNG**
DECENTRALIZED PLASMA ARC CONTROL
COMMANDE D'ARC À PLASMA DÉCENTRALISÉE

(30) Priorität: 24.11.2006 US 867159 P
(43) Veröffentlichungstag der Anmeldung: 02.09.2009
(73) Patentinhaber: TRUMPF Hüttinger GmbH + Co. KG, 79111 Freiburg im Breisgau (DE)
(72) Erfinder: NITSCHKE, Moritz, 79114 Freiburg (DE)
(74) Vertreter: Kohler Schmid Möbus Patentanwälte
(86) Internationale Anmeldenummer: PCT/EP2007/010200
(87) Internationale Veröffentlichungsnummer: WO 2008/061784

(56) Entgegenhaltungen:
- EP-A- 1 720 195
- DE-A1- 4 127 504
- US-A- 5 889 391
- US-A- 5 993 615
- US-A1- 2006 100 824
- US-B1- 6 332 961

## Beschreibung

Die Erfindung betrifft Plasmabearbeitungssysteme und Leistungsversorgungssysteme für solche Plasmabearbeitungs- oder Beschichtungsvorrichtungen, bei welchen elektrische Lichtbögen oder Arcs auftreten können, zum Beispiel zwischen Elektroden einer Plasmakammer, in der die Plasmabearbeitung oder das Beschichten stattfindet.

Aus der US 6,332,961 B1 ist ein Plasmaversorgungssystem bekannt, welches mehrere HF-Quellen aufweist, um ein Plasma in einer Plasmakammer zu erzeugen. Die Leistungsversorgungen werden durch eine Plasmasteuerung angesteuert, die wiederum mit einer Zentralsteuerung verbunden ist. Beim Erkennen eines Arcs kann die Leistung einer der HF-Quellen reduziert werden oder eine oder mehrere der HF-Quellen können abgeschaltet werden.

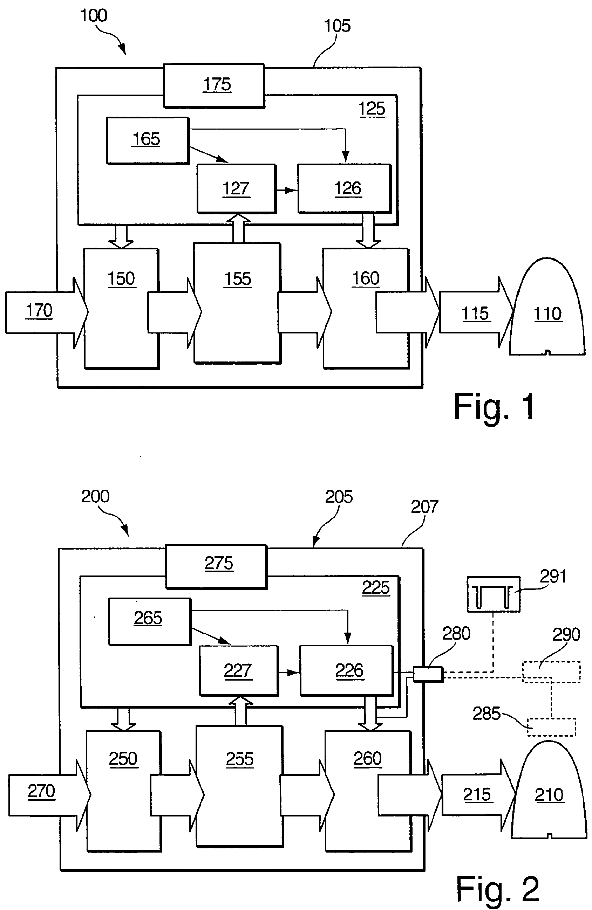

Unter Bezugnahme auf Fig. 1, die eine bekannte Vorrichtung darstellt, weist ein Plasmabearbeitungssystem 100 mindestens ein Leistungsversorgungssystem 105 auf, das einen Steuerabschnitt 125, einen Leistungswandler 150, einen Überwachungsabschnitt 155 und einen Arcableiter 160 umfasst. Der Steuerabschnitt 125 weist einen Arcableitersteuerabschnitt 126 auf, der mit dem Arcableiter 160 verbunden ist, und einen Arcerkennungsabschnitt 127, der mit dem Überwachungsabschnitt 155 und mit dem Arcableitersteuerabschnitt 126 verbunden ist. Das Leistungsversorgungssystem 105 führt Leistung zu einer Plasmakammer 110 über eine Stromleitungsverbindung 115 zu.

Der Leistungswandler 150 wandelt einen Wechselstromeingang 170 in ein Signal um, das Gleichstrom, Mittelfrequenz (zum Beispiel etwa 10 kHz bis etwa 500 kHz) oder Hochfrequenz (zum Beispiel 3 MHz bis etwa 100 MHz) sein kann. Der Überwachungsabschnitt 155 überwacht oder misst Spannung, Strom und/oder die Leistung des Signals des Leistungswandlers 150 und sendet die Messwerte zu dem Steuerabschnitt 125.

Der Arcableiter 160 soll auf ein Arcableitersteuersignal von dem Arcableitersteuerabschnitt 126 reagieren, indem er die Leistungszufuhr in das Plasma innerhalb der Plasmakammer 110 unterbindet, nachdem ein Arcableitersteuersignal aktiv wurde. Der Arcableiter 160 kann in bestimmten Fällen ein Parallelschalter sein, der sich schließt, oder Serienschalter, der sich in dem Fall eines aktiven Arcableitersteuersignals öffnet. Der Arc 160 wirkt solange das Arcableitersteuersignal von dem Arcableitersteuerabschnitt 126 aktiv ist. Die aktive Zeit kann eine vorgegebene Zeit sein, die eventuell vom Benutzer eingestellt werden kann.

Der Leistungswandler 150 kann auf das Arcableitersteuersignal reagieren, so dass der Leistungswandler 150 die Leistungszufuhr abschaltet, wenn das Arcableitersteuersignal aktiv wird. Der Leistungswandler 150 kann viel langsamer reagieren als der Arcableiter 160, so dass bei Plasmaprozessen, bei welchen eine niedrige Arcenergie erwünscht ist, ein Arcableiter 160 enthalten ist.

Der Steuerabschnitt 125 weist ein Bedienfeld 165 auf, das vom Benutzer zur Eingabe verwendet wird. Der Steuerabschnitt 125 weist auch eine Steuerschnittstelle 175 auf (wie zum Beispiel Digital-Analog-Eingänge/Ausgänge, RS232, Profibus usw.), die zur automatischen Steuerung des Leistungswandlers 150 durch den Benutzer oder für die Eingabe durch den Benutzer verwendet wird.

Der Arcerkennungsabschnitt 127 vergleicht die Messwerte von Leistung, Strom und/oder Spannung oder ihr dynamisches Verhalten mit Schwellenwerten. Der Arcerkennungsabschnitt 127 generiert als ein Ausgangssignal ein Arcableitersteuersignal, das in den Arcableitersteuerabschnitt 126 eingespeist wird. Das Arcableitersteuersignal ist aktiv, während ein Arc erkannt wird. Der Arcableitersteuerabschnitt 126 wandelt das Arcerkennungssignal von dem Arcerkennungsabschnitt 127 in ein Arcableitersteuersignal um, das zu dem Arcableiter 160 gesendet wird. Beim Empfang des Arcableitersteuersignals unterbindet der Arcableiter 160 (sofort oder so schnell wie möglich) den Leistungsfluss in die Plasmakammer 110. Der Arcableitersteuerabschnitt 126 gehört zu dem Steuerabschnitt 125 und hat eine Verbindung mit dem Bedienfeld 165 und Steuerschnittstelle 175. Derart können bestimmte der Parameter der Arcableitersteuerung durch einen Benutzer über die Schnittstelle 175 und/oder das Bedienfeld 165 geändert werden.

Die Schnittstelle 175 und/oder das Bedienfeld 165 kann einen Eingang für einen Benutzer zum Einstellen einer vorgegebenen Verzögerungszeit T_{D} haben, die innerhalb des Steuerabschnitts 125 oder innerhalb des Arcerkennungsabschnitts 127 gespeichert werden kann. Der Steuerabschnitt 125 aktiviert das Arcableitersteuersignal, nach Verstreichen der vorgegebene Verzögerungszeit T_{D}. Die Verzögerungszeit, die verstreicht, nachdem das Arcableitersteuersignal aktiv wird, kann durch den Benutzer eingestellt werden. Wenn der Arc daher von selbst innerhalb der Zeit T_{D}, nachdem das Arcableitersteuersignal aktiviert wurde, erlischt, aktiviert der Steuerabschnitt 125 das Arcableitersteuersignal nicht.

Die Schnittstelle 175 und/oder das Bedienfeld 165 kann einen Eingang für einen Benutzer aufweisen, um eine bestimmte Zeitdauer T_{P} einzustellen, während der das Arcableitersteuersignal aktiv gehalten wird, und die vorgegebene Zeitdauer T_{P} wird in dem Steuerabschnitt 125 gespeichert.

Die Schnittstelle 175 und/oder das Bedienfeld 165 kann einen Eingang aufweisen, der es einem Benutzer erlaubt, eine Schwelle für das Arcableitersteuersignal einzustellen. Die Schwelle wird verwendet, um die Größe bzw. den Wert des Arcableitersteuersignals zu bestimmen und wird vorzugsweise eingestellt, um den Arc so schnell wie möglich zu löschen (zum Beispiel Umkehrspannungsschwelle in Gleichstromleistungsversorgungen).

Die Steuerschnittstelle 175 kann einen vom Benutzer steuerbaren Kontakt aufweisen. Der steuerbare Kontakt wird PowerOn oder PowerOff genannt und dient dazu, um den Leistungswandler 150 ein- oder auszuschalten. Ein PowerOFF-Kontakt kann verwendet werden, wenn ein Arc von dem Benutzer erkannt wird. Die Reaktionszeit für ein solches System kann jedoch langsam sein, und eine hohe Menge an Energie kann in den Arc gelangen, bevor der Leistungswandler 150 abgeschaltet wird (und keine Leistung mehr sendet). Der Leistungswandler 150 kann mit einem PowerON-Signal wieder aktiviert werden, um das Plasma wieder zu zünden, aber dieser Vorgang kann langsam sein.

Plasmabearbeitungssysteme, wie zum Beispiel das System 100, das in Fig. 1 gezeigt ist, eignen sich für eine Anzahl potenzieller Anwendungen und werden zum Beispiel zum Targetsputtern verwendet. Typisch erzeugen Plasmabearbeitungssysteme, wie zum Beispiel das System 100, eine elektrische Leistung von ungefähr einigen kW bis zu über 100 kW. In typischen Fällen liegt die Betriebsspannung, die an die Elektroden oder Elektrode der Plasmakammer angelegt wird, in dem Bereich von etwa 400 V. Variationen aufwärts oder abwärts, auch als eine Funktion der jeweiligen Anwendung, sind möglich. Bei "reaktiven" Sputteranwendungen, einer Technik, die zum Beispiel zur Produktion von Oxid- oder Nitridfilmen oder in der Anwendung reaktiver Gase verwendet wird, treten Probleme aufgrund des zerstörenden Durchschlagens und/oder des Bildens von Isolierschichten auf dem leitenden Target auf, die zum Bilden störender Kondensatoren führen können. Sehr unterschiedliche passive und aktive Schaltungen wurden bekannt, um zum Löschen elektrischer Arcs zu dienen, die als das Ergebnis des zerstörenden Durchschlags entstanden sind. Diese Schaltungen unterbinden während einer definierten Zeitspanne nach dem Erfassen des Arcs das Liefern von Leistung zu den Elektroden. In Fig. 1 werden zum Beispiel der Stromfluss I und die Spannung U von dem Leistungswandler 150 durch den Überwachungsabschnitt 155 gemessen, der die Signale analysiert, um zu bestimmen, ob ein Arc innerhalb der Plasmakammer 110 aufgetreten ist.

Im Allgemeinen haben Leistungsversorgungssysteme (wie zum Beispiel das Leistungsversorgungssystem 105 der Fig. 1) zur Plasmabearbeitung ihre eigene Arcerkenunng, die durch eine oder mehrerer Strommessungen und einer Spannungsmessung (über den Überwachungsabschnitt 155) realisiert wird. Bei bestimmten Systemen wird die Spannung (oder die Stromstärke) von dem Leistungswandler 150 gemessen, und ein Arc wird erkannt, wenn die gemessene Spannung unter einem bestimmten Schwellenwert U_{ARC} sinkt. Der Schwellenwert kann als ein gleich bleibender oder ein variabler Wert festgelegt werden. Bei bestimmten Systemen kann eine Änderungsgeschwindigkeit in der Spannung (oder im Strom) (dv/dt) erfasst werden.

Der Arc kann mit einem Schalter (wie zum Beispiel dem Arcableiter 160) gelöscht werden, um die Menge an Energie zu verringern, die in die Plasmakammer 110 fließt. Der Schalter kann je nach der Lage und der Konfiguration des Schalters ein Parallelschalter sein, der geschlossen wird, oder ein Serienschalter, der geöffnet wird. Bei bestimmten Systemen kann das Schalten mit einer Spannungsumkehrung erfolgen, um den Arc insbesondere bei Gleichstromleistungsversorgungen zu löschen.

Wenn ein Arc an dem Ausgang des Leistungswandlers 150 erkannt wird und das Leistungsversorgungssystem 105 reagiert, um den Arc durch Verhindern des Leistungsflusses zu der Plasmakammer 110 zu löschen, ist es nicht immer möglich vorherzusehen, wie lange der Puls des Arcableitersteuersignals sein sollte. Ist der Puls zu kurz, wird der Arc nicht gelöscht, und während das Leistungsversorgungssystem versucht, Leistung in das Plasmabearbeitungssystem zu liefern, liefert es dem Arc Leistung und verursacht Schäden, die vermieden werden sollten. Ist die Dauer zu lang, kann die mittlere Leistung in das Plasmabearbeitungssystem hinein zu weit sinken, was nicht erstrebenswert ist. Lange Pulsdauern können eine Nachfrage nach der Spannungsschwelle zum Neuzünden des Plasmas steigern und ein ungleichmäßiges Beschichten verursachen.

Arcs verhalten sich in unvorhersehbarer Weise und machen es daher schwer, einen Arc durch Überwachen der Stromstärke oder der Spannung innerhalb des Leistungsversorgungssystems 105 mitzuverfolgen. Bestimmte Leistungsversorgungssysteme 105 bieten einen oder mehrere Steuereingänge, um es dem Benutzer des Leistungsversorgungssystems zu ermöglichen, die Dauer eines Arclöschpulses, des Werts der Umkehrspannung und anderer Pulsmerkmale zu steuern. Diese Merkmale können für jeden Verarbeitungszyklus voreingestellt werden und sind eventuell nicht für jeden einzelnen Puls steuerbar.

Zusätzlich kann die Stromleitungsverbindung zwischen dem Leistungsversorgungssystem und der Plasmakammer Induktivitäten und Kapazitäten, die von der Länge der Leistung zwischen dem Leistungsversorgungssystem und der Plasmakammer abhängen, erzeugen. Die Induktivitäten und Kapazitäten können für relativ langsame Arcerkennung vernachlässigbar sein, zum Beispiel zum Detektieren innerhalb mehrerer *µ*s. Für Arcerkennungszeiten unter etwa einer *µ*s können die Induktivität und Kapazität der Stromleitungsverbindung aber eine ernst zu nehmende Verzögerungszeit zwischen der Zeit, in der der Arc in dem Plasmabearbeitungssystem beginnt, und der Zeit, zu der der Arc in dem Leistungsversorgungssystem erkannt wird, verursachen.

Aus der US 5,889,391 ist eine Schaltung bekannt, mit der ein Plasma betrieben werden kann. Insbesondere können Strompulse an eine Plasmakammer gegeben werden. In regelmäßigen Abständen kann eine Umpolung erfolgen. Wird ein Arc erkannt, wird ein zweiter Schalter leitend geschaltet, um eine Umpolung zu erreichen.

Aufgabe der vorliegenden Erfindung ist es demgegenüber eine Vorrichtung und ein Verfahren mit einer verbesserten Arcsteuerung bereitzustellen.

Gelöst wir diese Aufgabe durch die Merkmale der unabhängigen Ansprüche. Ausgestaltungen finden sich in den Merkmalen der Unteransprüche.

Unter Bezugnahme auf Fig. 2 wird ein Plasmabearbeitungssystem 200 mit ähnlichen Merkmalen wie das System 100 der Fig. 1 erläutert. Das Plasmabearbeitungssystem 200 weist mindestens ein Leistungsversorgungssystem 205 auf, das einen Steuerabschnitt 225, einen Leistungswandler 250, einen Überwachungsabschnitt 255 und einen Arcableiter 260 aufweist. Der Steuerabschnitt 225 weist einen Arcableitersteuerabschnitt 226 auf, der mit dem Arcableiter 260 verbunden ist, und einen Arcerkennungsabschnitt 227, der mit dem Überwachungsabschnitt 255 und dem Arcableitersteuerabschnitt 226 verbunden ist.

Das Leistungsversorgungssystem 205 liefert Leistung zu einer Plasmakammer 210 über eine Stromleitungsverbindung 215. Das Leistungsversorgungssystem 205 weist ein Bedienfeld 265 und/oder eine Steuerschnittstelle 275 auf, das/die es dem Benutzer erlaubt, dem Leistungsversorgungssystem 205 zugeordnete Variablen und Einstellungen einzugeben.

Das Plasmabearbeitungssystem 200 weist ferner eine Eingabevorrichtung 280 auf, die vom Benutzer gesteuert werden kann, und die entweder direkt an den Arcableitersteuerabschnitt 226 oder direkt an das Arcableitersteuersignal von dem Arcerkennungsabschnitt 227 oder an beide angeschlossen ist. Die benutzersteuerbare Eingabevorrichtung 280 ist eine Schnittstellenvorrichtung, die auch als Schnittstelleneinheit bezeichnet wird, die es einem Benutzer erlaubt, das Arcableitersteuersignal direkt zu steuern, unabhängig von den Ergebnissen des Überwachungsabschnitts 255 oder des Ausgangs des Arcerkennungsabschnitts 227. Die Eingabevorrichtung 280 kann direkt von einem Benutzer betätigt werden. Bei bestimmten Beispielen weist die Eingabevorrichtung 280 einen Schalter auf, der von außerhalb des Leistungsversorgungssystems betätigt werden kann. In bestimmten Fällen ist die Eingabevorrichtung 280 ein Anschluss, der konfiguriert ist, um ein Arcableitersteuersignal von einer entfernt gelegenen Quelle zu empfangen.

Das Plasmabearbeitungssystem 200 kann eine Sensorvorrichtung 285 an der Plasmakammer 210 aufweisen, die an die Eingabevorrichtung 280 angeschlossen ist. Die Sensorvorrichtung kann von dem Leistungsversorgungssystem 205 entfernt angeordnet sein und sie kann zum Beispiel über eine kabellose Signalverbindung verbunden sein. Ein Auftreten eines Arcs in der Plasmakammer 210 kann große oder kleine Lichtblitze mit verschiedenen Wellenlängen erzeugen, zum Beispiel UV, IR oder sichtbares Licht. Die Lichtblitze können lange dauern, (zum Beispiel etwa 100 µs bis etwa 10 ms) oder kurz (zum Beispiel etwa einige ns bis mehrere µs). Die Lichtblitze können eine schnelle Anstiegszeit haben (zum Beispiel einige ns Anstiegszeit) oder eine langsame Anstiegszeit (zum Beispiel mehrere µs). Ein Auftreten eines Arcs in der Plasmakammer 210 kann Schallwellen erzeugen, zum Beispiel Knalle oder andere Geräusche. Ein Auftreten eines Arcs in der Plasmakammer 210 kann eine Störung in dem elektromagnetischen Signal der Elektroden innerhalb der Plasmakammer verursachen.

Das Plasmabearbeitungssystem 200 kann einen Steuerabschnitt 290 aufweisen, der zwischen der Sensorvorrichtung 285 und der Eingabevorrichtung 280 angeschlossen ist. Ein Signal von der Sensorvorrichtung 285 kann daher zuerst zu dem Steuerabschnitt 290 gesendet werden, wo das Signal geprüft, verglichen, berechnet usw. wird, und der Steuerabschnitt 290 kann ein Ausgangssignal zu dem Leistungsversorgungssystem 205 über die Eingabevorrichtung 280 senden. Wenn der Steuerabschnitt 290 zum Beispiel bestimmt, dass das Signal von der Sensorvorrichtung 285 einen auftretenden Arc anzeigt, kann der Steuerabschnitt 290 ein Alarmsignal zu der Eingabevorrichtung 280 senden.

Das Plasmabearbeitungssystem 200 kann einen Arc am Beginn, beim Entwickeln oder am Start des Arcs erfassen und bevor die Energie von dem Arc eine Gelegenheit erhält, sich stark auf das Plasmabearbeitungssystem auszuwirken. Ein solches Konzept ist bei Halbleiterherstellungssystemen von Nutzen, in welchen Arcs innerhalb von Millisekunden bis etwa Mikrosekunden nach dem Erkennen gelöscht werden sollten, und bei welchen die restliche Arcenergie möglichst gering sein sollte, zum Beispiel unter 1 mJ.

Das Plasmabearbeitungssystem 200 liefert schnellere Arcerkennung und verringert die Arcenergien und weist ein Leistungsversorgungssystem 205 auf, das ein solches Erkennen erlaubt. Das System 200 weist eine Eingabevorrichtung 280, wie zum Beispiel einen Eingabekontakt oder eine Eingabevorrichtung auf, die fester Bestandteil eines Leistungsversorgungssystems 205 ist. Die Eingabevorrichtung 280 stellt eine Benutzerschnittstelle bereit. Die Eingabevorrichtung 280 kann zum Beispiel elektrisch, analog oder digital, strom- oder spannungsgetrieben sein. Die Eingabevorrichtung 280 kann jedes geeignete Kommunikationssystem aufweisen, darunter zum Beispiel einen digitalen Bus wie PROFIBUS, DeviceNet, RS232, RS485 oder USB. Die Eingabevorrichtung 280 kann mit optischen Wellenleitern oder optischen Übertragungsgeräten verbunden sein, um zum Beispiel die Infrarot- oder Funkfrequenz-(HF)-Übertragung zu ermöglichen.

Die Eingabevorrichtungen 280 werden verwendet, um das Fließen von Leistung zu einem Arc in dem Plasmabearbeitungssystem 200 zu unterbinden. Die Eingabevorrichtung 280 kann zum Beispiel ein Lichtwellenleiteranschluss, ein elektrischer Anschluss oder ein HF-Eingang sein.

Bei bestimmten Ausführungsformen kann die Sensorvorrichtung 285 eine lichtempfindliche Vorrichtung aufweisen, die das Plasma in der Kammer 210 überwacht. Die Sensorvorrichtung 285 erfasst Arcs viel früher als ein signifikanter Spannungsabfall gemessen oder ein signifikanter Stromstärkenanstieg innerhalb des Leistungsversorgungssystems 205 erfasst werden könnte. Die Eingabevorrichtung 280 und/oder die Sensorvorrichtung 285 erlaubt daher schnellere Arcerfassung und schnellere Arcunterbrechung.

Bei bestimmten Ausführungsformen ist die Sensorvorrichtung 285 eine lichtempfindliche Vorrichtung, wie zum Beispiel ein lichtempfindlicher Widerstand, eine lichtempfindliche Diode oder eine CCD-Kamera, die ein elektrisches Signal aus einem Lichtsignal bildet. Das elektrische Signal von der Sensorvorrichtung 285 kann direkt zu der Eingabevorrichtung 280 des Leistungsversorgungssystems 205 gesendet werden.

Die Sensorvorrichtung 285 weist eine lichtempfindliche Vorrichtung auf, die auf Licht im sichtbaren Spektrum, im Ultraviolettspektrum (UV) oder im Infrarotspektrum (IR) reagiert. Die Sensorvorrichtung 285 kann mehrere lichtempfindliche Vorrichtungen aufweisen, wobei jede Vorrichtung auf Licht mit einem unterschiedlichen Lichtspektrum reagiert.

Die Länge, der Wert, die Form und andere Merkmale des Pulses von dem Arcableitersteuerabschnitt 226 können angepasst werden, um das weitere Entwickeln des sich bildenden Arcs zu unterbinden.

Bei anderen Ausführungsformen kann das Licht von der Sensorvorrichtung 285 direkt an das Leistungsversorgungssystem 205 gesendet werden, ohne in ein elektrisches Signal umgewandelt zu werden. Das Licht von einer lichtempfindlichen Sensorvorrichtung 285 kann zum Beispiel über Wellenleiter oder kabellos direkt zu dem Leistungsversorgungssystem 205 gesendet werden.

Der Steuerabschnitt 290 kann eine Benutzerschnittstelle aufweisen, wie zum Beispiel eine Tastatur, eine Computermaus und/oder ein Rad. Der Steuerabschnitt 290 kann Register zum Aufzeichnen von Werten zum Vergleich mit Schwellenwerten aufweisen. Aufgezeichnete Werte umfassen zum Beispiel die Verzögerungszeit T_{D}, die Zeitdauer T_{P} oder den Pegel des Arcableitersteuersignals. Der Steuerabschnitt 290 kann eine logisch-arithmetische Einheit aufweisen, um digitale Daten zu verarbeiten. Der Steuerabschnitt 290 kann einen schnellen Analog-Digital-Wandler zum Umwandeln des Messsignals an der Plasmakammer 210 in digitale Werte aufweisen und sie dann verarbeiten. Der Steuerabschnitt 290 kann ein Display aufweisen, um zum Beispiel einen Zustand der registrierten Werte zu zeigen.

Das Plasmabearbeitungssystem 200 sorgt für ein Senken der in einen Arc gelieferten Leistung bei Werten, die für unerreichbar gehalten wurden.

Das Plasmabearbeitungssystem 200 kann für Wechselstromquellen verwendet werden, bei welchen es schwierig sein kann, Arcs schnell genug zu erkennen, weil Spannung und Stromstärke sich mit der Zeit ändern und Durchschnittswerte als Schwellenwerte verwendet werden.

Die Sensorvorrichtung 285 kann die Arclöschzeit gut genug messen, so dass die Zeit, während der ein Puls aktiv ist, mit Präzision und einzeln für jeden Arc gesteuert werden könnte.

Die Sensorvorrichtung 285 kann eine galvanische Trennung zwischen der Plasmakammer 210 und dem Leistungsversorgungssystem 205 realisieren, zum Beispiel, wenn die Sensorvorrichtung 285 Lichtwellenleiter, Lichtübertragung oder HF-Übertragung aufweist.

Die Eingabevorrichtung 280 kann eine digitale Eingabe in digitaler Datenübertragungsart sein, wie zum Beispiel CAN, USB, RS232, RS485, PROFIBUS, DeviceNet, LAN usw. Die Eingabevorrichtung 280 kann jedes geeignete schnurlose Übertragungssystem wie zum Beispiel HF-Übertragung (AM, FM, WLAN, Bluetooth, IR, GSM, usw.) verwenden, solange das Übertragungssystem schnell genug ist.

Bei bestimmten Ausführungsformen weist die Sensorvorrichtung 285 eine Schallüberwachungsvorrichtung auf, die innerhalb der Plasmakammer 210 Schallparameter überwacht, wie zum Beispiel Knalle, Geräusche oder das Ändern von Geräuschen. Die Sensorvorrichtung 285 kann Schallüberwachung zusätzlich zu anderen Messungen, wie zum Beispiel optischen Messungen verwenden. Die Sensorvorrichtung 285 kann Ultraschall- oder Infraschallüberwachung verwenden.

Die Sensorvorrichtung 285 kann elektromagnetische Wellen in der Plasmakammer 210 zum Erfassen von Arcs messen.

Die Sensorvorrichtung 285 kann den Elektroden innerhalb der Plasmakammer 210 zugeordnete Spannung und/oder Stromstärke messen. Eine solche direkte Spannungs- und/oder Stromstärkemessung innerhalb der Plasmakammer 210 hilft dabei, die Verzögerungen zu vermeiden, die mit dem Messen von Spannung oder Stromstärke in dem Leistungsversorgungssystem 205 verbunden sind, in dem die Spannung oder der Strom aufgrund der Kapazität und Induktivität der Stromleitung verzögert werden können. Die Sensorvorrichtung 285 kann Spannungssensoren oder Langmuir-Sonden in der Plasmakammer 210 verwenden, die Ladungen in der Plasmakammer überwachen und Abweichungen lange vor dem vollen Ausbilden eines Arcs erfassen.

Wie gezeigt, wird die Eingabevorrichtung 280 als getrennter Eingang in das Leistungsversorgungssystem 205 bereitgestellt. Bei bestimmten Ausführungsformen kann die Eingabevorrichtung 280 jedoch auf dem Bedienfeld 265 oder der Steuerschnittstelle 275 angeordnet werden. Die Eingabevorrichtung 280 stellt eine unabhängige Möglichkeit für einen Benutzer bereit, den Arcableitersteuerabschnitt 226 zu betätigen oder den Arcableiter 260 zu aktivieren, um den Strom von dem Leistungsversorgungssystem 205 her zu unterbrechen, ohne auf eine Arcerkennungsbetrachtung seitens des Arcerkennungsabschnitt 227 und des Überwachungsabschnitts 255 warten zu müssen. Die Eingabevorrichtung 280 stellt daher für einen Benutzer eine direkte Möglichkeit bereit, das Löschen eines Arcs in der Plasmakammer 210 zu steuern.

Das Leistungsversorgungssystem 205 kann ein Gehäuse 207 aufweisen, das den Leistungswandler, den Arcableiter 260, den Überwachungsabschnitt 255 und den Steuerabschnitt 225 enthält. Die Eingabevorrichtung 280 kann auf einer Außenfläche des Leistungsversorgungssystemgehäuses installiert werden.

Wenn die Eingabevorrichtung 280 kombiniert mit der Sensorvorrichtung 285 verwendet wird, kann das System automatisiert werden. Wenn die Sensorvorrichtung 285 mit der Eingabevorrichtung 280 gekoppelt ist, könnte die Eingabevorrichtung 280 zwei Eingänge aufweisen, einen, damit ein Benutzer direkt das Arcableitersteuersignal steuern kann, und einen für eine automatische Steuerung nach Maßgabe des Steuerabschnitts 290 (ohne Eingabe vom Benutzer her). Unter automatischer Steuerung bestimmt der Steuerabschnitt 290 basierend auf dem Signal von der Sensorvorrichtung 285, ob in der Plasmakammer 210 ein Arc auftritt, und sendet ein Signal zu der Eingabevorrichtung 280 oder direkt zu dem Arcableitersteuerabschnitt 226, um den Arcableiter 260 zu aktivieren.

Wenn das Arcableitersteuersignal durch automatische Steuerung über den Steuerabschnitt 290 aktiviert wird, kann der Arcableitersteuerabschnitt 226 nach Bedarf von dem Arcerkennungsabschnitt 227 abgekoppelt werden. Die Eingabevorrichtung 280 kann einen Eingang aufweisen, damit ein Benutzer auswählen kann, ob er den Arcableitersteuerabschnitt 226 über den Benutzer an der Eingabevorrichtung 280 oder über den Arcerkennungsabschnitt 227 steuert.

Bei bestimmten Ausführungsformen kann das Initiieren eines Ars in der Plasmakammer 210 von dem Überwachungsabschnitt 255 kombiniert mit dem Arcerkennungsabschnitt 227 erfasst werden, und dann kann die Dauer des Arcs von dem Benutzer oder durch die Sensorvorrichtung 285 über die Eingabevorrichtung 280 erfasst werden. Bei diesen Ausführungsformen wird der Beginn des Arcableitersteuersignals von dem Arcableitersteuerabschnitt 226 durch das Arcerkennungssignal von dem Arcerkennungsabschnitt 227 ausgelöst, und das Ende des aktiven Zustands des Arcableitersteuersignals wird von der Eingabevorrichtung 280 ausgelöst. Eine derartige Konzeption kann in Situationen oder bei Anwendungen von Nutzen sein, in welchen der Überwachungsabschnitt 225 besser dazu geeignet ist, einen beginnenden Arc zu bestimmen, und der Benutzer und/oder die Sensorvorrichtung 285 besser geeignet ist, um das Arcende zu bestimmen.

Bei bestimmten Ausführungsformen kann das Initiieren eines Arcs in der Plasmakammer 210 von dem Benutzer oder von der Sensorvorrichtung 285 über die Eingabevorrichtung 280 erfasst werden, und die Dauer des Arcs kann von dem Überwachungsabschnitt 255 kombiniert mit dem Arcerkennungsabschnitt 227 erfasst werden.

Bei bestimmten Ausführungsformen kann der Arcableiter.steuerabschnitt 226 konfiguriert werden, um ein Arcableitersteuersignal nur zu dem Arcableiter 260 zu senden, wenn sowohl die Eingabevorrichtung 280 als auch der Arcerkennungsabschnitt 227 anzeigen, dass ein Arc in der Plasmakammer 210 gegenwärtig ist.

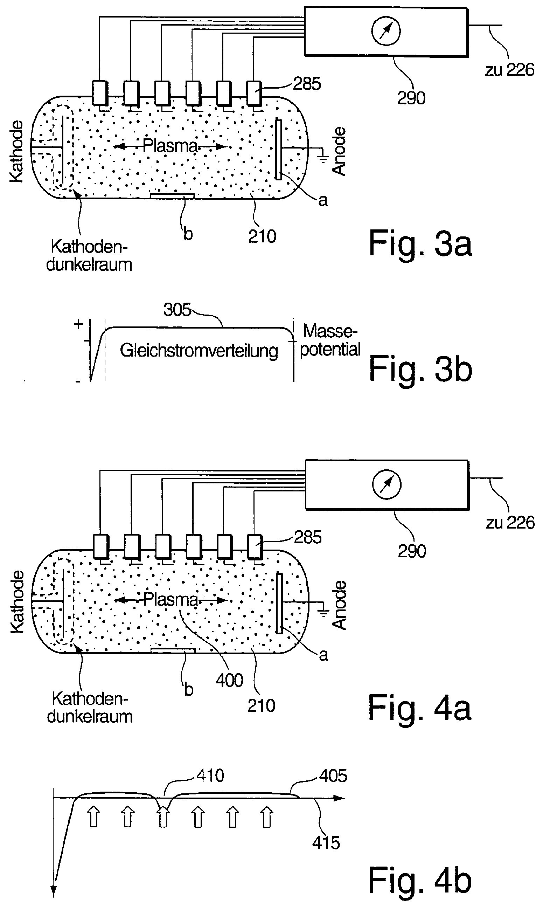

Unter Bezugnahme auf Fig. 3A und 3B ist die Plasmakammer 210 mit der Sensorvorrichtung 285 gezeigt, die mit dem Steuerabschnitt 290 (wie in Fig. 2 gezeigt) oder mit der Eingabevorrichtung 280 gekoppelt werden kann. Bei dieser Konzeption weist die Sensorvorrichtung 285 sechs Messvorrichtungen, wie zum Beispiel Langmuir-Sonden auf, und das Signal von der Sensorvorrichtung 285 ist in Fig. 3B gezeigt. Während des Betriebs ohne Auftreten eines Fehlers ist die Signalverteilung 305 von der Sensorvorrichtung 285 ziemlich ausgeglichen.

Unter Bezugnahme auf die Fig. 4A und 4B tritt ein Arc 400 innerhalb der Plasmakammer 210 auf. Die Signalverteilung 405 von der Sensorvorrichtung 285 zeigt ein Ereignis 410, das unter einen Schwellenwert 415 fällt.

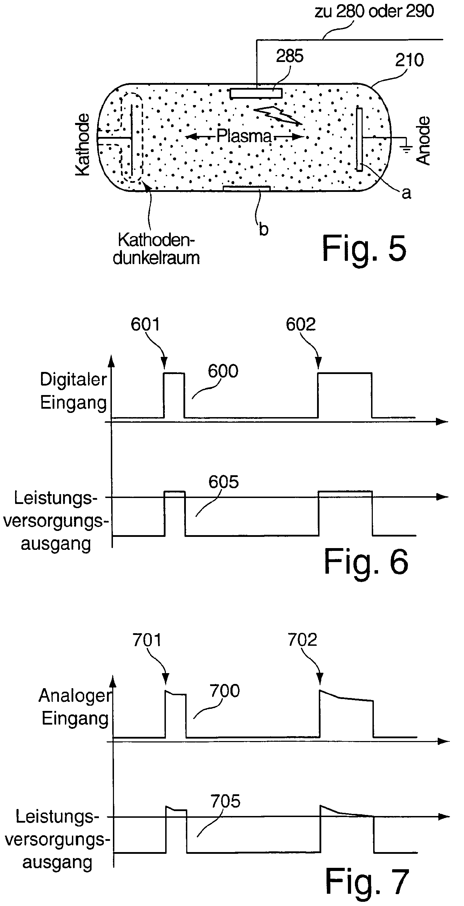

Unter Bezugnahme auf Fig. 5 tritt ein Arc 500 innerhalb der Plasmakammer 210 auf, und die Sensorvorrichtung 285 ist als eine lichtempfindliche Vorrichtung konfiguriert, die Licht erfasst, das von dem Arc innerhalb der Plasmakammer 210 abgegeben wird. Die Sensorvorrichtung 285 kann sich innerhalb der Plasmakammer oder außerhalb der Plasmakammer 210 befinden, wenn die Plasmakammer 210 ein Fenster aufweist.

Unter Bezugnahme auf Fig. 6 und wenn die Eingabevorrichtung 280 ein digitaler Schnittstelleneingang zu dem Leistungsversorgungssystem 205 ist, kann die Länge des Eingangsimpulses 600 von der Eingabevorrichtung 280 die gleiche Länge sein wie die Länge des Impulses 605 zu dem Arcableiter 260 und durch die Leitung 215. Ein Arc wird im Zeitpunkt 601 erfasst, und die Eingabevorrichtung 280 erzeugt einen Puls, der das Auftreten des Arcs anzeigt und während der Lebensdauer des Arcs dauert. Ein zweiter Arc wird im Zeitpunkt 602 erfasst, und die Eingabevorrichtung 280 erzeugt einen Puls, der das Auftreten des Arcs anzeigt und während der Lebensdauer des Arcs dauert. Wie gezeigt, hat der zweite Arc eine längere Dauer als der erste Arc.

Unter Bezugnahme auf Fig. 7 und wenn die Eingabevorrichtung 280 ein analoger Schnittstelleneingang zu dem Leistungsversorgungssystem 205 ist, kann die Länge des Eingangspulses 700 von der Eingabevorrichtung 280 die Länge des Pulses 705 zu dem Arcableiter 260 und durch die Stromleitung 215 sein, und die Spannung des Eingangspulses 700 kann zu der Spannung des Ausgangspulses 705 proportional sein. Ein Arc wird im Zeitpunkt 701 erfasst, und die Eingabevorrichtung 280 erzeugt einen Puls, der das Auftreten des Arcs anzeigt und der während der Lebensdauer des Arcs dauert. Ein zweiter Arc wird im Zeitpunkt 702 erfasst, und die Eingabevorrichtung 280 erzeugt einen Puls, der das Auftreten des Arc anzeigt und während der Lebensdauer des Arc dauert. Wie gezeigt, dauert der zweite Arc länger als der erste Arc.

In beiden Fällen kann die Zeitdauer des Arcableitersteuersignals von der Lebensdauer des einzelnen Arcs abhängen und braucht nicht auf dem voreingestellten Schwellenwert T_{P} zu sein, der unveränderlich ist. Ein solches Konzept ist möglich, weil die Eingabevorrichtung 280 das Auftreten und Löschen eines Arcs schneller erkennen kann als der Überwachungsabschnitt 255, der eventuell nicht erkennen kann, dass der Arc erloschen ist, ohne den Arc mit Strom versorgen zu müssen.

Bei bestimmten Plasmabearbeitungssystemen könnte es hilfreich sein, ein wechselndes Verhalten des Arcableiters 260 über die Zeit zu bestimmen, um einen Arc schneller löschen zu helfen. Bei Gleichstromversorgungen sind zum Beispiel eine Größe der Spannungsumkehrung und eine Änderung in der Spannungsumkehrung im Laufe der Zeit des Arcableiters Werte, die bestimmt werden können. Bei Mittelfrequenz- oder Hochfrequenzstromversorgungen kann ein Transistor als ein Arcableiter verwendet werden. Bei bestimmten Konzeptionen kann der Transistor nicht in einem Schritt geschaltet werden, sondern zuerst auf einen ohmschen Zustand getrieben werden, der von der Plasmaladung abhängt, und dann, nach einer kurzen Zeit, zu einem höheren ohmschen Zustand oder komplett ausgeschaltet. In diesem Fall kann die Eingabevorrichtung 280 ein analoger Eingang sein, und der Benutzer kann für jedes Auftreten eines Arcs die Verhaltensweise des Arcableiters, den Startpunkt, die Größe der Spannungsumkehrung oder den Arcableiterwiderstand über die Zeit bestimmen, um den Arc so schnell wie möglich zu löschen. Der analoge Eingang kann das Signal 700 sein, das in Fig. 7 gezeigt ist, und der Leistungsausgang in einem mit Gleichstrom versorgten Plasmabearbeitungssystem kann das wie in Fig. 7 gezeigte Signal 705 sein.

Die Eingabevorrichtung 280 der Figur 2 ist eine Schnittstellenvorrichtung, die ebenso eine Ausgabefunktion umfassen kann. Eine "Open-Kollektor-Einheit" ist beispielsweise eine geeignete Schnittstellenvorrichtung, die sowohl eine Eingabeeinheit als auch eine Ausgabeeinheit ist. Eine solche Schnittstellenvorrichtung könnte für den Arcableiter 260 sowohl direkt als auch über den Arcableitersteuerabschnitt 226 ein Eingang sein und gleichzeitig ein Ausgang des Arcableitersteuerabschnitts 226. Mit solch einer Schnittstellenvorrichtung ist es möglich, mehrere Leistungsversorgungssysteme mit unterschiedlichem Arcerkennungsverhalten oder unterschiedlichem Pulsverhalten zu synchronisieren. Es ist ebenso möglich, einen Steuerabschnitt mit einer oder mehreren Leistungsversorgungssystemen zu verbinden. Der Steuerabschnitt kann dann ein Signal auf der Verbindungsleitung empfangen und ebenso Signale über diese Verbindungsleitung senden.

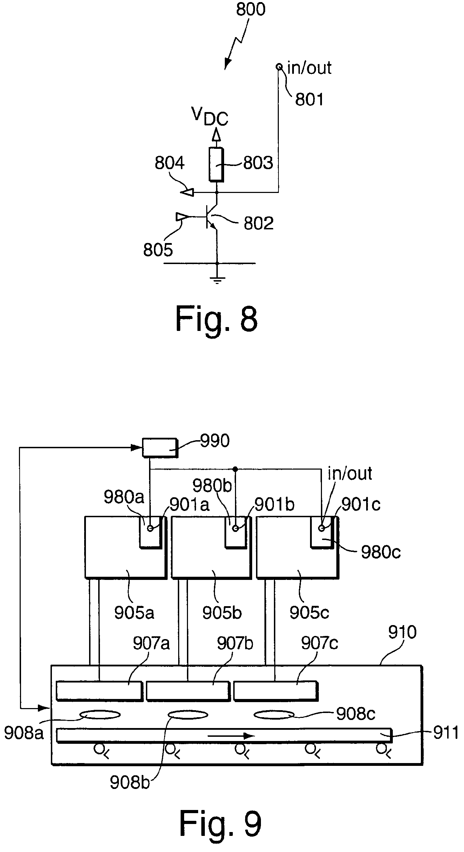

In der Figur 8 ist eine Arcschnittstellenvorrichtung 800 (auch Arcschnittstelleneinheit genannt) mit einem Eingabe-/Ausgabeanschluss 801, einem Schalttransistor 802, einem Widerstand 803, der eine relativ hohe Impedanz (z.B. einen Wert zwischen 1 und 1000kΩ) aufweist und der ein Spannungspotenzial an dem Eingabe-/Ausgabeanschluss 801 und an dem Messpunkt 804 auf einem Potenzial von V_{DC} hält. Wenn das Ansteuersignal 805 aktiv ist, was bedeuten kann, dass ein Arc erkannt wurde, schaltet der Transistor an oder geht von einer hohen Impedanz (sehr viel höher als der Widerstand 803) zu einer niedrigen Impedanz (sehr viel geringer als der Widerstand 803). Dadurch ändert sich das Spannungspotenzial an dem Messpunkt 804 und an dem Eingabe-/Ausgabeanschluss 801 von nahezu V_{DC} auf nahezu das Massepotenzial. Das gleiche passiert, wenn der Eingabe-/Ausgabeanschluss 801 durch eine externe Quelle verändert wird (z.B. durch einen Steuerabschnitt 290 oder ein zweites Leistungsversorgungssystem mit derselben Arcschnittstelleneinheit 800.

In der Figur 9 ist ein Plasmabearbeitungssystem mit einer Plasmakammer 910 gezeigt, durch die ein Substrat 911 transportiert wird. Beispielhaft sind drei Elektroden 907a, 907b, 907c in der Plasmakammer gezeigt. Die Elektroden werden durch die drei Leistungsversorgungssysteme 905a, 905b, 905c, mit Leistung versorgt, um ein Plasma 908a, 908b, 908c zu erzeugen. Jede der Leistungsversorgungssysteme 905a, 905b, 905c umfasst eine Arcschnittstelleneinheit 980a, 980b, 980c, die der Arcschnittstelleneinheit 800 der Figur 7 entspricht, und einen Eingabe-/Ausgabeanschluss 901a, 901b, 901c, die dem Eingabe-/Ausgabeanschluss 801 in Figur 7 entsprechen. Alle drei Leistungsversorgungssysteme 905a, 905b, 905c sind durch eine einzelne Leitung an ihren Eingabe-/Ausgabeanschlüssen 901a, 901b, 901c miteinander verbunden. Eine zusätzliche Verbindung zu einer weiteren Quelle oder Messeinrichtung oder Steuereinrichtung 990 ist gezeigt. Diese Steuereinrichtung 990 kann so ausgebildet sein, dass sie auch das Plasmabearbeitungssystem steuert, wie z.B. den Gasfluss, die Transportgeschwindigkeit des Substrats in der Kammer 910 etc.

In einem Ausführungsbeispiel der Erfindung wird die Eingabevorrichtung 280 dazu verwendet, das Pulsen eines Leistungsversorgungssystems (wie in der Fig. 2 gezeigt) zu steuern. Die Pulsfrequenz und/oder die Länge von jedem Puls sind dann durch eine externe Quelle (direkt) steuerbar. Die externe Quelle kann ein Frequenzgenerator 291 oder ein Steuerabschnitt 290 sein, der auch Bestandteil der Steuerung des gesamten Plasmaprozesses sein kann, was bedeutet, dass z.B. die Gasflusssteuerung die Leistungssteuerung von einem oder unterschiedlichen Leistungsversorgungssystemen zusammenarbeiten oder in Reihe im Plasmaprozess zusammenarbeiten können. Wenn die Eingabevorrichtung 280 ein analoger Eingang ist, kann die externe Quelle (290, 291) auch die Qualität oder Wellenform des Arcableiters steuern, wie oben beschrieben ist.

In anderen Ausführungsformen der Erfindung ist der Arcableitersteuerabschnitt 226 durch einen Benutzer über die Steuerschnittstelle 275 oder das Steuerbedienfeld 265 konfigurierbar. Beispielsweise kann die Reaktion des Arcableitersteuerabschnitts auf von dem Arcerkennungsabschnitt 227 und/oder der Arcschnittstelleneinrichtung oder Eingabevorrichtung 280 gesendete Signale konfiguriert werden.

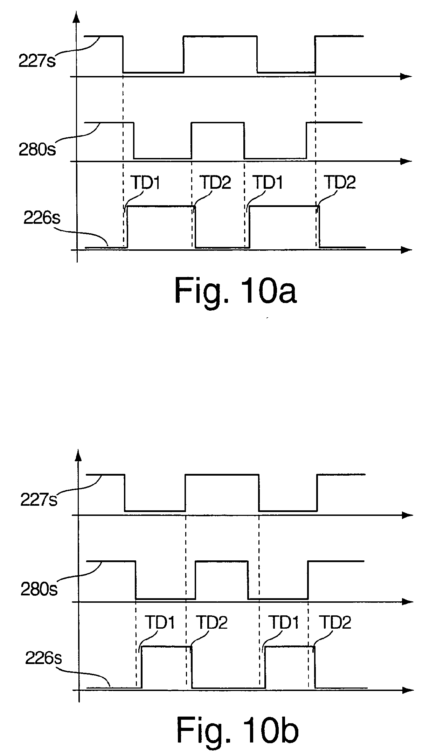

Dies wird mit Bezug zu den Figuren 10a-10d anhand einiger Beispiele im Detail beschrieben.

Das in der Figur 10a gezeigte Signal 227s von dem Arcerkennungsabschnitt 227 und das Signal 280s von der Eingabevorrichtung 280 sind beide im "Low-Zustand" aktiv. Sie steuern ein Ausgangssignal 226s des Arcableitersteuerabschnitts 226, das den Arcableiter 260 ansteuert. Wenn die Signale 227s und 226s über eine NAND-Funktion miteinander verbunden sind, entspricht das Ausgangssignal 226s des Arcableitersteuerabschnitts 226, das den Arcableiter 260 ansteuert, dem Signal 226s, das in der Figur 10a gezeigt ist. Dies bedeutet, dass der Arcableiter aktiviert wird, wenn eines der Signale 227s oder 280s aktiv ist. Es kann eine benutzerdefinierbare oder automatisch veränderbare Zeitverzögerung TD1 zwischen dem aktiven Zustand von 227s oder 280s und der Reaktion des Signals 226s vorgesehen sein. Es kann ebenso eine benutzerkonfigurierbare oder automatisch veränderbare Zeitverzögerung TD2 zwischen dem inaktiven Zustand von 227s und 280s und der Reaktion des Signals 226s vorgesehen sein.

Das in der Figur 10b gezeigte Signale 227s des Arcableiterabschnitts 227 und das Signal 280s der Eingabevorrichtung 280 sind wiederum in ihrem "Low-Zustand" aktiv. Wenn sie mit einer NOR-Funktion verbunden werden, entspricht das Ausgangsignal 226s des Arcableitersteuerabschnitts 226, welches den Arcableiter 260 ansteuert, dem Signal 226s, das in der Figur 10b gezeigt ist. Dies bedeutet, dass der Arcableiter nur aktiviert wird, wenn beide Signale 227s und 280s aktiv sind. Es kann eine benutzerkonfigurierbare oder automatisch veränderbare Zeitverzögerung TD1 zwischen dem aktiven Zustand von 227s und 280s und der Reaktion des Signals 226s vorgesehen sein. Es kann eine benutzerkonfigurierbare oder automatisch veränderbare Zeitverzögerung TD2 zwischen dem inaktiven Zustand von 227s oder 280s und der Reaktion des Signal 226s vorgesehen sein.

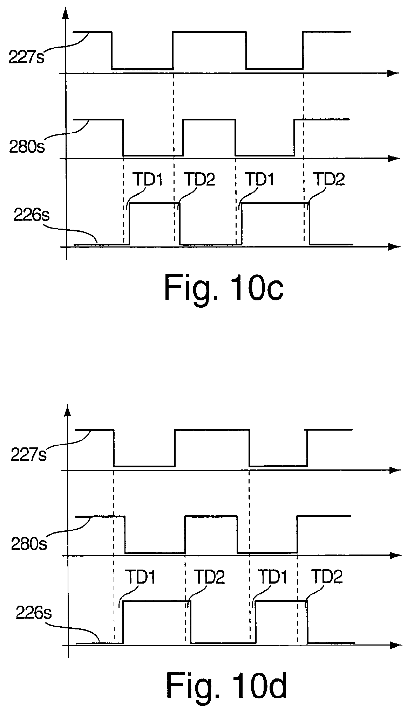

Das in der Figur 10c gezeigte Signal 227s von dem Arcerkennungsabschnitt 227 und das Signal 280s von der Eingabevorrichtung 280 sind wiederum in ihrem "Low-Zustand" aktiv. Wenn sie mit der Funktion "set und reset" verbunden werden, entspricht das Ausgangssignal 226s des Arcableitersteuerabschnitts 226, welches den Arcableiter 260 ansteuert, dem in der Figur 10c gezeigten Signal 226s. Dies bedeutet, dass der Arcableiter aktiviert wird, nachdem 280s aktiv wurde, und deaktiviert wird, nachdem 227s deaktiviert wurde. Es kann eine benutzerkonfigurierbare oder automatisch veränderbare Zeitverzögerung TD1 zwischen dem aktiven Zustand von 227s und 280s und der Reaktion des Signals 226s vorgesehen sein. Es kann eine benutzerkonfigurierbare oder automatisch veränderbare Zeitverzögerung TD2 zwischen dem inaktiven Zustand von 227s oder 280s und der Reaktion des Signal 226s vorhergesehen sein.

In der Figur 10d ist das Signal 227s von dem Arcerkennungsabschnitt 227 und das Signal 280s von der Eingabevorrichtung 280 gezeigt, die wiederum beide in einem"Low-Zustand" aktiv sind. Wenn sie mit einer der "set und reset" entgegengesetzten Funktionalität verbunden werden, entspricht das Ausgangsignal 226s des Arcableitersteuerabschnitts 226, der den Arcableiter 260 ansteuert, dem Signal 226s, das in der Figur 10d gezeigt ist. Dies bedeutet, dass der Arcbableiter aktiviert wird, nachdem 227s aktiv wurde, und deaktiviert wird, nachdem 280s deaktiviert wurde. Es kann eine benutzerkonfigurierbare oder automatisch veränderbare Zeitverzögerung TD1 zwischen dem aktiven Zustand von 227s und 280s und der Reaktion des Signals 226s vorgesehen sein. Es kann eine benutzerkonfigurierbare oder automatisch veränderbare Zeitverzögerung TD2 zwischen dem inaktiven Zustand von 227s oder 280s und der Reaktion des Signals 226s vorgesehen sein. Andere Verknüpfungsmöglichkeiten sind ebenfalls denkbar, wie z.B AND, OR, EXOR. Die Signale 226s, 227s, und 280s können in einem "Low-Zustand" oder "High-Zustand" aktiv sein. Ebenfalls kann der Zustand von einem der Signale berücksichtigt werden für die Reaktion des Signals 226s.

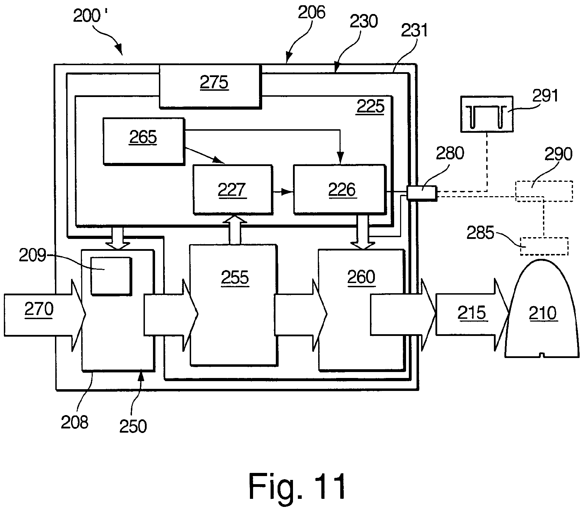

In der Figur 11 ist ein Plasmabearbeitungssystem 200' mit einem Leistungsversorgungssystem 206 gezeigt. Das Leistungsversorgungssystem 206 kann ein Arcableitersystem 230 und, um ein Plasma mit Leistung zu versorgen, einen Leistungswandler 250, der in einem separaten Gehäuse 208 angeordnet ist, umfassen.

Der Leistungswandler 250 kann seinen eigenen Steuerabschnitt 209 aufweisen. Das Arcableitersystem 230 kann ein Gehäuse 231 umfassen, das den Arcableiter 260 den Überwachungsabschnitt 255 und den Steuerabschnitt 225 umgibt. Die Eingabevorrichtung 280 kann außen an dem Arcableitersystem 230 angeordnet sein.

Der Leistungswandler 250 dient der Leistungsversorgung des Plasmaprozesses. Er kann separat vorgesehen sein oder in ein Leistungsversorgungssystem eingebunden sein, das auch die mit der Arcerkennung in Zusammenhang stehenden Elemente und den Arcableiter umfasst.

## Patentansprüche

1. Plasmaleistungsversorgungssystem (200), welches elektrische Leistung erzeugt, für ein Plasmabearbeitungssystem, wobei das Plasmaleistungsversorgungssystem Leistung über eine Leitung (215) an eine Plasmakammer (210) liefert, das Plasmaleistungsversorgungssystem einen Leistungswandler (250), einen Überwachungsabschnitt (255), einen Steuerabschnitt (225), einen Arcableitersteuerabschnitt (226), einen Arcerkennungsabschnitt (227) und eine durch einen Benutzer steuerbare Eingabevorrichtung (280) umfasst, wobei ein Arcableiter (260) vorgesehen und die Eingabevorrichtung mit dem Arcableiter verbunden ist, **dadurch gekennzeichnet, dass** die Eingabevorrichtung eingerichtet ist, die Länge eines durch die Eingabevorrichtung empfangenen E ingangspulses zu erkennen und ein Signal mit derselben oder einer damit in Beziehung stehenden Länge an den Arcableiter auszugeben, wobei das Plasmaleistungsversorgungssystem elektrische Leistung im Bereich zwischen 1kW und 100kW erzeugt.

2. Plasmaleistungsversorgungssystem nach Anspruch 1, **dadurch gekennzeichnet, dass** die Eingabevorrichtung direkt mit dem Arcableiter verbunden ist, oder dass die Eingabevorrichtung über den Arcableitersteuerabschnitt mit dem Arcableiter verbunden ist.

3. Plasmaleistungsversorgungssystem nach einem der vorhergehenden Ansprüche, **dadurch gekennzeichnet, dass** die Eingabevorrichtung ein digitaler oder analoger Eingang ist.

4. Plasmaleistungsversorgungssystem nach einem der vorhergehenden Ansprüche, **dadurch gekennzeichnet, dass** die Eingabevorrichtung mit einem kabellosen Übertragungssystem kompatibel ist.

5. Plasmaleistungsversorgungssystem nach einem der vorhergehenden Ansprüche, **dadurch gekennzeichnet, dass** die Eingabevorrichtung mit einer Sensoreinrichtung (285) verbunden ist, die von dem Plasmaleistungsversorgungssystem entfernt angeordnet ist.

6. Plasmaleistungsversorgungssystem nach einem der vorhergehenden Ansprüche, wobei der Arcableitersteuerabschnitt von der Eingabevorrichtung ein erstes Signal und von dem Arcerkennungsabschnitt ein zweites Signal empfängt, wobei der Arcableitersteuerabschnitt zur Ansteuerung des Arcableiters ein Signal erzeugt, indem das erste und
zweite Signal gemäß einer oder mehrerer der folgenden Funktionen verbunden werden:
a) NOR
b) NAND,
c)Set/Reset,
d)OR,
e) AND,
f) EXOR.

7. Plasmaleistungsversorgungssystem nach Anspruch 6,
**dadurch gekennzeichnet, dass** der Arcableitersteuerabschnitt derart eingerichtet ist, dass das Arcableitersteuersignal um eine konfigurierbare Zeitverzögerung, nachdem eine der Funktionen "wahr" ist, aktiviert wird.

8. Plasmaleistungsversorgungssystem nach Anspruch 6 oder 7,
**dadurch gekennzeichnet, dass** der Arcableitersteuerabschnitt derart eingerichtet ist, dass das Arcableitersteuersignal eine konfigurierbare Zeitverzögerung, nachdem eine der Funktionen "falsch" ist, deaktiviert ist.

9. Plasmaleistungsversorgungssystem nach einem der vorhergehenden Ansprüche, **dadurch gekennzeichnet, dass** die Eingabevorrichtung einen Eingabe-/Ausgabeanschluss umfasst.

10. Plasmaleistungsversorgungssystem nach einem der vorhergehenden Ansprüche, **dadurch gekennzeichnet, dass** die Eingabevorrichtung eingerichtet ist, die Wellenform eines von der Eingabevorrichtung
empfangenen Signals zu erfassen und den Arcableiter derart anzusteuern, dass am Ausgang des Leistungsversorgungssystems eine Pulswellenform erzeugt wird, die dem Signal an der Eingabevorrichtung entspricht oder zu diesem proportional ist.

11. Plasmabearbeitungssystem, umfassend eine Plasmakammer, um ein zu bearbeitendes Objekt aufzunehmen, und ein Plasmaleistungsversorgungssystem nach einem der Ansprüche 1 bis 10.

12. Verfahren zum Zuführen von Leistung zu einer Plasmabearbeitungskammer über eine Leistungsversorgung, wobei das Verfahren Folgendes umfasst:
Umwandeln von Netzleistung in Leistung, die aufbereitet ist, um einen Plasmaprozess zu versorgen,
Überwachen der umgewandelten Netzleistung,
Erzeugen eines Überwachungssignals, das die umgewandelte überwachte Leistung anzeigt,
Bestimmen, ob das erzeugte Signal ein Auftreten eines Arcs innerhalb der Plasmakammer anzeigt,
Unterbinden des Fließens umgewandelter Leistung von dem Leistungsversorgungssystem zu der Plasmakammer in Abhängigkeit vom Bestimmen, dass das erzeugte Überwachungssignal das Auftreten eines Arcs anzeigt,
**gekennzeichnet durch**
Empfangen eines Fern-Eingabesignals von einem Benutzer von außerhalb des Leistungversorgungssystems her, das ein Auftreten eines Arcs innerhalb der Plasmakammer anzeigt,
Unterbinden des Fließens umgewandelter Leistung von dem Leistungversorgungssystem zu der Plasmakammer indem die Länge eines Eingangspulses des Fern-Eingabesignals erkannt wird und ein Signal mit derselben oder einer damit in Beziehung stehenden Länge an einen Arcableiter ausgegeben wird.

13. Verfahren nach Anspruch 12, wobei das Unterbinden des Fließens umgewandelter Leistung von dem Leistungsversorgungssystem das Unterbinden unabhängig von dem erzeugten Überwachungssignal umfasst.

14. Verfahren nach Anspruch 12 oder 13, das ferner das Empfangen des Fern-Eingabesignals von einem Sensor, der sich an der Plasmakammer befindet, umfasst, wobei der Sensor ein Ereignis an der Plasmakammer misst.

15. Verfahren nach einem der Ansprüche 12 bis 14, wobei das Unterbinden des Fließens umgewandelter Leistung zu der Plasmakammer das Empfangen des Ferneingabesignals und Bestimmen auf der Grundlage des Fern-Eingangsignals, ob ein Arc aufgetreten ist, umfasst.

## Claims

1. Plasma power supply system (200), which produces electrical power, for a plasma processing system, the plasma power supply system supplying the power to a plasma chamber (210) through a power line (215), the plasma power supply system comprising a power converter (250), a monitoring section (255), a control section (225), an arc diverter control section (226), an arc detection section (227), and a user controllable input device (280), wherein an arc diverter (260) is provided and the input device is connected to the arc diverter, **characterized in that** the input device is designed to detect the length of an input pulse received by the input device and to output a signal to the arc diverter of the same length or a length which is related thereto, wherein the plasma power supply system generates electrical power in the range between 1kW and 100kW.

2. Plasma power supply system according to claim 1, **characterized in that** the input device is directly connected to the arc diverter or the input device is connected to the arc diverter through the arc diverter control section.

3. Plasma power supply system according to any one of the preceding claims, **characterized in that** the input device is a digital or an analog input.

4. Plasma power supply system according to any one of the preceding claims, **characterized in that** the input device is compatible with a cordless transmission system.

5. Plasma power supply system according to any one of the preceding claims, **characterized in that** the input device is connected to a sensor device (285) which is arranged remote from the plasma power supply system.

6. Plasma power supply system according to any one of the preceding claims, wherein the arc diverter control section receives a first signal from the input device and a second signal from the arc detection section, wherein the arc diverter control section generates a signal to drive the arc diverter by combining the first and second signals according to
one or more of the following functions
a) NOR,
b) NAND,
c) Set/Reset,
d) OR,
e) AND,
f) EXOR.

7. Plasma power supply system according to claim 6, **characterized in that** the arc diverter control section is designed in such a manner that the arc diverter control signal is activated a configurable time delay after one of the functions has become "true" .

8. Plasma power supply system according to claim 6 or 7, **characterized in that** the arc diverter control section is designed in such a manner that the arc diverter control signal is deactivated a configurable time delay after one of the functions has become "false".

9. Plasma power supply system according to any one of the preceding claims, **characterized in that** the input device comprises an IN/OUT connection.

10. Plasma power supply system according to any one of the preceding claims, **characterized in that** the input device is designed to detect the wave shape of a signal received by the input device and to control the arc diverter in such a manner that a pulse wave shape is produced at the output of the power supply system which corresponds to or is proportional to the signal at the input device.

11. Plasma processing system comprising a plasma chamber for receiving an object to be processed, and a plasma power supply system in accordance with any one of the claims 1 through 10.

12. A method of supplying power to a plasma processing chamber through a power supply, the method comprising:
converting mains power to power conditioned to power a plasma process;
monitoring the converted mains power;
generating a monitor signal indicative of the monitored converted power;
determining whether the generated signal indicates an occurrence of an arc within the plasma chamber;
determining whether the generated signal indicates an occurrence of an arc within the plasma chamber;
inhibiting flow of converted power from the power supply system to the plasma chamber in dependence on the determination that the generated monitoring signal indicates the occurrence of an arc,
**characterized by**
receiving a remote input signal from a user external to the power supply system indicative of an occurrence of an arc within the plasma chamber;
inhibiting flow of converted power from the power supply system to the plasma chamber in that the length of an input pulse of the remote input signal is detected and a signal of the same length or a length relating thereto is output to an arc diverter.

13. The method of claim 12, wherein inhibiting the flow of converted power from the power supply system includes inhibiting independently of the generated monitor signal.

14. The method of claim 12 or 13, which moreover includes receiving the remote input signal from a sensor located at the plasma chamber, wherein the sensor measures an event at the plasma chamber.

15. The method of any one of the claims 12 through 14, wherein inhibiting the flow of converted power to the plasma chamber includes receiving the remote input signal and determining whether an arc occurred based on the remote input signal.

## Revendications

1. Système d'alimentation en puissance de plasma (200), lequel produit une puissance électrique pour un système de traitement par plasma, le système d'alimentation en puissance de plasma fournissant de la puissance à une chambre à plasma (210) via une conduite (215), le système d'alimentation en puissance de plasma comprenant un convertisseur de puissance (250), une section de surveillance (255), une section de commande (225), une section de commande de suppresseur d'arc (226), une section de détection d'arc (227) et un dispositif d'entrée (280) pouvant être commandé par un utilisateur, un suppresseur d'arc (260) étant prévu et le dispositif d'entrée étant relié au suppresseur d'arc, **caractérisé en ce que** le dispositif d'entrée est conçu pour détecter une impulsion d'entrée reçue par le dispositif d'entrée et fournir au suppresseur d'arc un signal de même longueur ou d'une longueur en rapport avec celle-ci, le système d'alimentation en puissance de plasma produisant une puissance électrique dans la plage comprise entre 1 kW et 100 kW.

2. Système d'alimentation en puissance de plasma selon la revendication 1, **caractérisé en ce que** le dispositif d'entrée est relié directement au suppresseur d'arc, ou que le dispositif d'entrée est relié au suppresseur d'arc par l'intermédiaire de la section de commande de suppresseur d'arc.

3. Système d'alimentation en puissance de plasma selon l'une des revendications précédentes, **caractérisé en ce que** le dispositif d'entrée est une entrée numérique ou analogique.

4. Système d'alimentation en puissance de plasma selon l'une des revendications précédentes, **caractérisé en ce que** le dispositif d'entrée est compatible avec un système de transmission sans fil.

5. Système d'alimentation en puissance de plasma selon l'une des revendications précédentes, **caractérisé en ce que** le dispositif d'entrée est relié à un dispositif de détection (285) qui est disposé à distance du système d'alimentation en puissance de plasma.

6. Système d'alimentation en puissance de plasma selon l'une des revendications précédentes, dans lequel la section de commande de suppresseur d'arc reçoit du dispositif d'entrée un premier signal et de la section de détection d'arc un deuxième signal, la section de commande de suppresseur d'arc générant un signal pour la commande du suppresseur d'arc en combinant le premier et le deuxième signal selon une ou plusieurs des fonctions suivantes :
a) NOR
b) NAND,
c) Set/Reset,
d) OR,
e) AND,
f) EXOR.

7. Système d'alimentation en puissance de plasma selon la revendication 6, **caractérisé en ce que** la section de commande de suppresseur d'arc est conçue de façon que le signal de commande de suppresseur d'arc soit activé avec un retard configurable après qu'une des fonctions est « vraie ».

8. Système d'alimentation en puissance de plasma selon la revendication 6 ou la revendication 7, **caractérisé en ce que** la section de commande de suppresseur d'arc est conçue de façon que le signal de commande de suppresseur d'arc soit désactivé avec un retard configurable après qu'une des fonctions est « fausse ».

9. Système d'alimentation en puissance de plasma selon l'une des revendications précédentes, **caractérisé en ce que** le dispositif d'entrée comprend un port d'entrée/sortie.

10. Système d'alimentation en puissance de plasma selon l'une des revendications précédentes, **caractérisé en ce que** le dispositif d'entrée est conçu pour détecter la forme d'onde d'un signal reçu par le dispositif d'entrée et pour commander le suppresseur d'arc de façon que soit générée à la sortie du système d'alimentation en puissance une forme d'onde d'impulsion qui correspond au signal au dispositif d'entrée ou est proportionnelle à celui-ci.

11. Système de traitement par plasma, comprenant une chambre à plasma destinée à recevoir un objet à traiter et un système d'alimentation en puissance selon l'une des revendications 1 à 10.

12. Procédé pour amener de la puissance à une chambre de traitement par plasma par une alimentation en puissance, le procédé comprenant les étapes consistant à :
convertir une puissance du réseau en une puissance apte à alimenter un procédé plasma,
surveiller la puissance du réseau convertie,
générer un signal de surveillance qui indique la puissance convertie surveillée,
déterminer si le signal généré indique la survenue d'un arc à l'intérieur de la chambre à plasma,
empêcher l'écoulement d'une puissance convertie du système d'alimentation en puissance vers la chambre à plasma en fonction de la détermination que le signal de surveillance généré indique la survenue d'un arc,
**caractérisé par** les étapes consistant à :
recevoir un signal d'entrée distant d'un utilisateur à partir de l'extérieur du système d'alimentation en puissance de plasma, qui indique une survenue d'un arc à l'intérieur de la chambre à plasma,
empêcher l'écoulement d'une puissance convertie du système d'alimentation en puissance vers la chambre à plasma en détectant la longueur d'une impulsion d'entrée du signal d'entrée distant et en fournissant à un suppresseur d'arc un signal de même longueur ou d'une longueur en rapport avec celle-ci.

13. Procédé selon la revendication 12, selon lequel l'étape consistant à empêcher l'écoulement d'une puissance convertie du système d'alimentation en puissance consiste à l'empêcher indépendamment du signal de surveillance généré.

14. Procédé selon la revendication 12 ou la revendication 13, comprenant en outre l'étape consistant à recevoir le signal d'entrée distant d'un capteur qui se trouve sur la chambre à plasma, le capteur mesurant un événement sur la chambre à plasma.

15. Procédé selon l'une des revendications 12 à 14, selon lequel l'étape consistant à empêcher l'écoulement d'une puissance convertie vers la chambre à plasma consiste à recevoir le signal d'entrée distant et à déterminer, sur la base du signal d'entrée distant, si un arc est survenu.
